# EUROPEAN PATENT SPECIFICATION

(11) **EP 4 333 038 B1**
(45) Date of publication and mention of the grant of the patent: **11.11.2026**
(21) Application number: 23184930.8
(22) Date of filing: 12.07.2023
(51) Int. Cl.: H10W 20/00, H10W 20/42, H10W 20/47

(54) **SEMICONDUCTOR DEVICE**
HALBLEITERANORDNUNG
DISPOSITIF SEMI-CONDUCTEUR

(30) Priority: 31.08.2022 KR 20220109786
(43) Date of publication of application: 06.03.2024
(73) Proprietor: Samsung Electronics Co., Ltd., Suwon-si, Gyeonggi-do 16677 (KR)
(72) Inventor: SONG, Minjun, 16677 Suwon-si (KR); LEE, Jongmin, 16677 Suwon-si (KR); SHIN, Joongwon, 16677 Suwon-si (KR); LEE, Nara, 16677 Suwon-si (KR); CHOI, Jimin, 16677 Suwon-si (KR)
(74) Representative: Marks & Clerk LLP

(56) References cited:
- US-A1- 2020 035 613
- US-A1- 2022 208 687

## Description

### BACKGROUND

### 1. Field

Example embodiments relate to a semiconductor device. Particularly, example embodiments relate to a semiconductor device including an upper wiring structure.

### 2. Description of the Related Art

In general, a semiconductor device may include circuit patterns and an upper wiring structure including stacked wirings electrically connecting the circuit patterns. As the semiconductor device is highly integrated, a height of the upper wiring structure may increase, and a vertical thermal resistance may increase due to the upper wiring structure.

US 20220208687 A1 discloses a semiconductor device including a substrate, multi-level interconnections disposed on the substrate, a first passivation layer containing hydrogen and covering top interconnections among the multi-level interconnections, a second passivation layer disposed over the first passivation layer to prevent out-diffusion of the hydrogen from the first passivation layer, an in-line top dielectric layer over the second passivation layer, an in-line redistribution layer connected to one among the top interconnections by passing through the in-line top dielectric layer, the second passivation layer, and the first passivation layer; and a hydrogen blocking liner disposed between the in-line redistribution layer and the first passivation layer.

### SUMMARY

The invention provides a semiconductor device as claimed in claim 1.

### BRIEF DESCRIPTION OF THE DRAWINGS

Features will become apparent to those of skill in the art by describing in detail embodiments of the invention with reference to the attached drawings in which:
FIG. 1 is a cross-sectional view of a semiconductor device according to example embodiments.
FIG. 2 is a cross-sectional view of a portion including an uppermost wiring in FIG. 1.
FIGS. 3 to 10 are cross-sectional views illustrating a method of manufacturing a semiconductor device.
FIG. 11 is a cross-sectional view of a semiconductor device according to example embodiments.
FIG. 12 is an enlarged view of a disclosed embodiment of portion A of FIG. 11.

### DETAILED DESCRIPTION

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete.

In the figures, the dimensions of layers and regions may be exaggerated for clarity of illustration. It will also be understood that when a layer or element is referred to as being "on" another layer or substrate, it can be directly on the other layer or substrate, or intervening layers may also be present. Further, it will be understood that when a layer is referred to as being "under" another layer, it can be directly under, and one or more intervening layers may also be present. In addition, it will also be understood that when a layer is referred to as being "between" two layers, it can be the only layer between the two layers, or one or more intervening layers may also be present. Like reference numerals refer to like elements throughout.

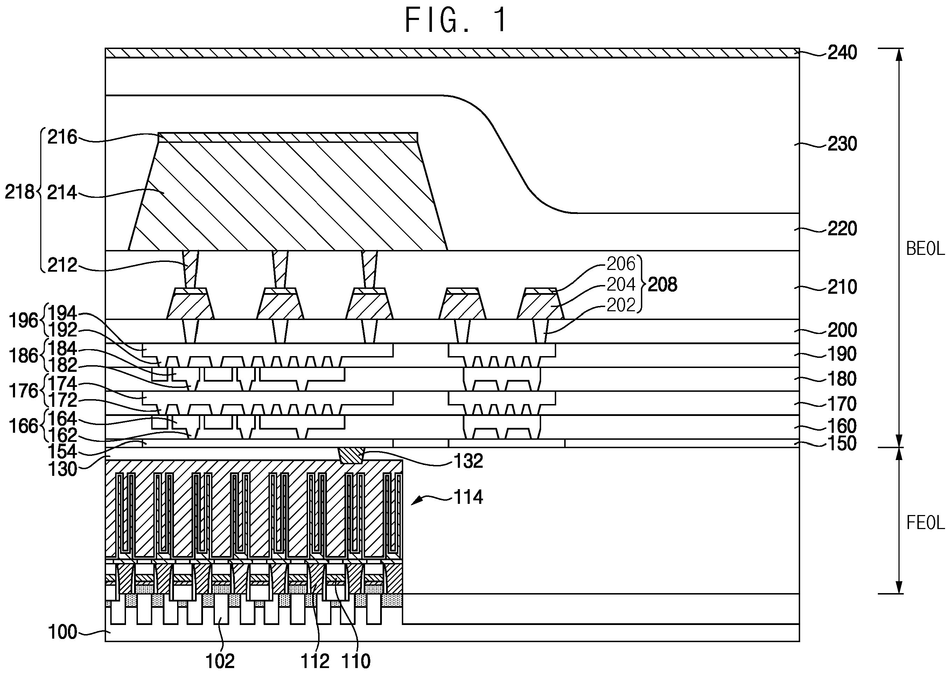

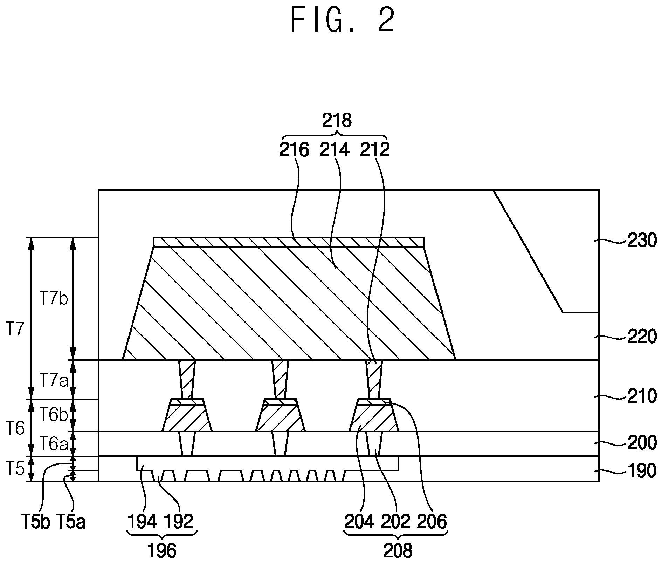

FIG. 1 is a cross-sectional view of a semiconductor device according to example embodiments. FIG. 2 is a cross-sectional view of a portion including an uppermost wiring in FIG. 1.

In this example embodiment, it may be described that the semiconductor device is a DRAM device.

Referring to FIGS. 1 and 2, a front end of line (FEOL) structure may be on a substrate 100, and a back end of line (BEOL) structure may be on the FEOL structures.

Circuit patterns serving as the FEOL structure may be on the substrate 100. The FEOL structure may include memory cells and core/peripheral circuits. The BEOL structure may include metal wirings (i.e., metal interconnections) for electrically connecting the circuit patterns in the FEOL structure. First, the FEOL structure on the substrate 100 may be described.

An isolation pattern 102 for defining an active region may be on the substrate 100. Cell transistors, bit line structures 110, first lower wirings 112 and capacitors 114 for constituting memory cells may be on the substrate 100. Hereinafter, the cell transistors, bit line structures 110, first lower wirings 112, and capacitors 114 on the substrate 100 are collectively referred to as a memory cell structure.

A lower insulating interlayer 130 may be on the substrate 100 to cover the memory cell structure. A contact plug 132 electrically connected to the capacitor 114 may be further included in the lower insulating interlayer 130.

A BEOL structure on the FEOL structure may be described. Low-k dielectric layers 150, 160, 170, 180, and 190 and upper insulating interlayers 200 and 210 may be sequentially on the lower insulating interlayer 130 and the contact plug 132. Wirings may be inside and on the low-k dielectric layers 150, 160, 170, 180, and 190 and the upper insulating interlayers 200 and 210.

Low-k dielectric layers 150, 160, 170, 180, and 190 may be on the lower insulating interlayer 130, and upper interlayer dielectric layers 200 and 210 may be on an uppermost low-k dielectric layer (i.e., 190).

In an implementation, first to fifth low-k dielectric layers 150, 160, 170, 180 and 190 may be stacked on the lower insulating interlayer 130. First to fifth wirings 154, 166, 176, 186, and 196 may be formed in the first to fifth low-k dielectric layers 150, 160, 170, 180, and 190, respectively. The number of the low-k dielectric layers and wirings may not be limited thereto.

In example embodiments, the low-k dielectric layers 150, 160, 170, 180, and 190 may be insulation layers having a dielectric constant smaller than 4.4. In an implementation, the low-k dielectric layers 150, 160, 170, 180, and 190 may include, e.g., SiCOH.

In example embodiments, the first wiring 154, which is a lowest wiring in the BEOL structure, include a first metal pattern. Each of the second to fifth wirings 166, 176, 186, and 196 may include a via and a metal pattern. In an implementation, the second wiring 166 may include a second via 162 and a second metal pattern 164, and the third wiring 176 may include a third via 172 and a third metal pattern 174. The fourth wiring 186 may include a fourth via 182 and a fourth metal pattern 184, and the fifth wiring 196 may include a fifth via 192 and a fifth metal pattern 194. In example embodiments, the first to fifth wirings 154, 166, 176, 186, and 196 may include, e.g., copper.

The second to fifth wirings 166, 176, 186, and 196 may have second to fifth thicknesses, respectively. The second to fifth thicknesses may be the same as or different from each other. In example embodiments, each of the second to fifth thicknesses may be in range of about 4000 Å to about 8000 Å.

Meanwhile, the first wiring 154 may include only the first metal pattern, so that a first thickness of the first wiring may be less than each of the second to fifth thicknesses - for example, the first wiring 154 need not include a via. In example embodiments, the first thickness may be in a range of about 1000 Å to about 3000 Å.

In the n-th wiring (e.g., n is 2 to 5) including the via and the metal pattern, a thickness of the n-th via may be greater than 50% of a thickness of the n-th metal pattern. Also, the thickness of the n-th via may be less than the thickness of the n-th metal pattern. In an implementation, as shown in FIG. 2, the thickness of the fifth via T5a may be greater than 50% of the thickness T5b of the fifth metal pattern, in the fifth wiring. However, thicknesses of the via and metal pattern may be controlled according to an electrical target of the wiring.

In the n-th wiring, the thickness of the n-th via divided by a thickness of the n-th metal pattern multiplied by 100 may be defined as an n-th via thickness ratio, and the n-th via thickness ratio may be in range of about 50% to about 100%. In an implementation, the n-th via thickness ratio may be about 75% to about 95%.

First and second upper insulating interlayers 200 and 210 may be on the fifth low-k dielectric layer 190, which is an uppermost low-k dielectric layer. A sixth wiring 208 and an uppermost wiring 218 may be formed inside and on the first and second upper insulating interlayers 200 and 210. The sixth wiring 208 may be positioned right below the uppermost wiring 218. The first and second upper insulating interlayers 200 and 210 may have a dielectric constant higher than the dielectric constant of each of the low-k dielectric layers 150, 160, 170, 180 and 190.

The first upper insulating interlayer 200 may include a silicon oxide-based material. The first upper insulating interlayer 200 may include, e.g., tetraethyl orthosilicate (TEOS), boro-phosphosicateglass (BPSG), tonen sazene (TOSZ), undoped silicate glass (USG), or spin-on glass (SOG).

In example embodiments, the first upper insulating interlayer 200 might not be used as an oxide layer for supplying hydrogen. In an implementation, the first upper insulating interlayer 200 might not include a high density plasma (HDP) oxide layer.

A sixth via 202 may be formed in the first upper insulating interlayer 200. A sixth metal pattern 204 may be on the first upper insulating interlayer 200, and may contact the sixth via 202. The sixth wiring may include the sixth via and a sixth metal pattern.

In example embodiments, the sixth via 202 may include, e.g., tungsten. In example embodiments, the sixth metal pattern 204 may include, e.g., tungsten. In an implementation, a first barrier metal pattern 206 may be further included on the sixth metal pattern 204. The first barrier metal pattern 206 may include titanium, (Ti), tantalum (Ta), or a nitride thereof. As used herein, the term "or" is not an exclusive term, e.g., "A or B" would include A, B, or A and B.

The sixth wiring 208 may have a sixth thickness T6. The sixth thickness T6 may be greater than each of the first to fifth thicknesses. In example embodiments, the sixth thickness T6 may be in range of about 7000 Å to about 12000 Å.

A thickness T6a of the sixth via may be greater than 30% of a thickness of the sixth metal pattern T6b. Also, the thickness T6a of the sixth via may be less than the thickness of the sixth metal pattern T6b. In an implementation, the sixth via thickness ratio may be about 30% to about 100%. In example embodiments, the sixth via thickness ratio may be less than each of the first to fifth via thickness ratios. In an implementation, the sixth via thickness ratio may be about 40% to about 70%. However, the thickness of each of the sixth via and the sixth metal pattern may be controlled according to an electrical target of the sixth wiring 208.

An uppermost via 212 may be formed in the second upper insulating interlayer 210. An uppermost metal pattern 214 may be on the second upper insulating interlayer 210, and may contact the uppermost via 212. The uppermost wiring 218 may include the uppermost via 212 and the uppermost metal pattern 214.

The uppermost metal pattern 214 may contact a bump pad. Also, a bump may be on the bump pad. Accordingly, the uppermost metal pattern may be electrically connected to the bump.

The second upper insulating interlayer 210 may include at least silicon oxide. In example embodiments, the second upper insulating interlayer 210 may include one layer, or may include stacked two or more layers including different insulation materials.

In example embodiments, the second upper insulating interlayer 210 might not include silicon nitride. In some example embodiments, the second upper insulating interlayer 210 may include silicon nitride.

In example embodiments, the second upper insulating interlayer 210 might not be used as an oxide layer for supplying hydrogen. In an implementation, the second upper insulating interlayer 210 might not include a high density plasma (HDP) oxide layer.

In example embodiments, the uppermost via 212 may include tungsten. The uppermost metal pattern 214 may include a metal material different from that of the uppermost via 212. In example embodiments, the uppermost metal pattern 214 may include aluminum. In an implementation, the uppermost metal pattern 214 may include an aluminum pattern. In addition, a second barrier metal pattern 216 may be further included on an upper surface of the aluminum pattern. The second barrier metal pattern 216 may include at least one of titanium, (Ti), tantalum (Ta), and a nitride thereof.

The uppermost wiring 218 may have a seventh thickness T7. The seventh thickness T7 may be higher than each of the first to sixth thicknesses. In example embodiments, the seventh thickness T7 may be about 25,000 Å or more. In an implementation, the seventh thickness T7 may be about 25000 Å to about 45000 Å.

In example embodiments, the uppermost metal pattern 214 may have a thickness higher than each of the first to sixth thicknesses. In example embodiments, the uppermost metal pattern 214 may have the thickness of 20000 Å or more. In an implementation, the uppermost metal pattern 214 may have the thickness of about 20000 Å to about 40000 Å.

A thickness T7a of the uppermost via is less than 40% of a thickness T7b of the uppermost metal pattern. In an implementation, the thickness T7a of the uppermost via may be about 20% to about 35% of the thickness T7b of the uppermost metal pattern. In an implementation, the uppermost via thickness ratio (thickness of the uppermost via divided by a thickness of the uppermost metal pattern multiplied by 100) is less than about 40%. In example embodiments, the uppermost via thickness ratio may be less than each of the first to sixth thickness ratios.

The seventh thickness T7 of the uppermost wiring 218 may be greater than thickness of each of other wirings (i.e., each of the first to sixth wirings). Therefore, the uppermost wiring 218 may greatly affect the vertical thermal resistance of the upper wiring structure. However, since the uppermost via thickness ratio is less than about 40%, the thickness of the uppermost via 212 may be less than the thickness of the uppermost metal pattern 214. Accordingly, the seventh thickness T7 of the uppermost wiring 218 may be decreased. The vertical thermal resistance generated by a thick thickness of the uppermost wiring 218 may be decreased.

An oxide layer 220 for supplying hydrogen is on the second upper insulating interlayer 210 and the uppermost metal pattern 214 to cover the second upper insulating interlayer 210 and the uppermost metal pattern 214. The oxide layer 220 for supplying hydrogen may be silicon oxide containing hydrogen in the layer. The oxide layer for supplying hydrogen may include a high density plasma (HDP) oxide layer.

In processes for manufacturing the semiconductor device, dangling bonds may be generated at an interface between the gate insulation layer of a cell transistor and the substrate 100. In the semiconductor device, leakage currents may increase due to the dangling bonds. In a case of the DRAM device, a refresh operation, which rewrites data stored in the memory cell, may be performed. In order to improve a speed and a durability of the DRAM device, a cycle of the refresh operation (i.e., data retention time) may be increased. However, when the dangling bonds are included at the interface between the gate insulation layer and the substrate 100, leakage currents may be generated in the cell transistor and transistors in peripheral circuits. Thus, the data retention time of the DRAM device may be decreased. Therefore, removing of the dangling bonds at the interface between the gate insulation layer and the substrate 100 may be required.

The oxide layer 220 for supplying hydrogen may be provided to supply hydrogen to the interface between the gate insulation layer and the substrate 100. The oxide layer 220 for supplying hydrogen may be an oxide containing hydrogen. When hydrogen is supplied to the interface between the gate insulation layer and the substrate 100, the dangling bonds may be removed by combining hydrogen with the dangling bonds. Accordingly, in the DRAM device, the leakage currents due to the dangling bonds may be decreased and the data retention time may be increased.

In addition, the oxide layer 220 for supplying hydrogen may be provided to reduce a step difference of an upper surface. In example embodiments, the step difference of the upper surface of the oxide layer 220 for supplying hydrogen may be lower than the step difference of the upper surfaces between the uppermost metal pattern 214 and the second upper insulating interlayer 210.

A thickness of the oxide layer 220 for supplying hydrogen may be greater than 40% of the thickness of the uppermost metal pattern 214, and less than the thickness of the uppermost metal pattern 214. When the thickness of the oxide layer 220 for supplying hydrogen is less than 40% of the thickness of the uppermost metal pattern 214, the step difference of the upper surface of the oxide layer 220 for supplying hydrogen may be high. In addition, when the thickness of the oxide layer 220 for supplying hydrogen is greater than the thickness of the uppermost metal pattern 214, a thickness of an uppermost insulating interlayer 230 formed thereon may be decreased and thus a flatness of the uppermost insulating interlayer 230 may be decreased.

In example embodiments, the thickness of the oxide layer 220 for supplying hydrogen may be greater than the thickness of the uppermost via 212. The oxide layer 220 for supplying hydrogen must have a sufficient thickness required for supplying hydrogen. In an implementation, the thickness of the oxide layer 220 for supplying hydrogen may be about 10000 Å or more.

The uppermost insulating interlayer 230 may be on the oxide layer 220 for supplying hydrogen. An upper surface of the uppermost insulating interlayer 230 may be substantially flat. The uppermost insulating interlayer 230 may include silicon oxide having a high flatness of an upper surface thereof. The uppermost insulating interlayer 230 may include, e.g., TEOS layer.

An upper capping layer 240 may be on the uppermost insulating interlayer 230. The upper capping layer 240 may include, e.g., silicon nitride. The upper capping layer 240 may prevent hydrogen diffused from the oxide layer 220 for supplying hydrogen from moving upward. Accordingly, the hydrogen diffused (or, supplied) from the oxide layer 220 for supplying hydrogen may move in a direction toward the upper surface of the substrate 100.

In the semiconductor device, the vertical thermal resistance may decrease as the thickness of the uppermost wiring decreases. In addition, as hydrogen may be supplied to the substrate 100, the dangling bonds between the substrate 100 and the gate insulation layer may be decreased. Therefore, electrical characteristics of the semiconductor device may be improved.

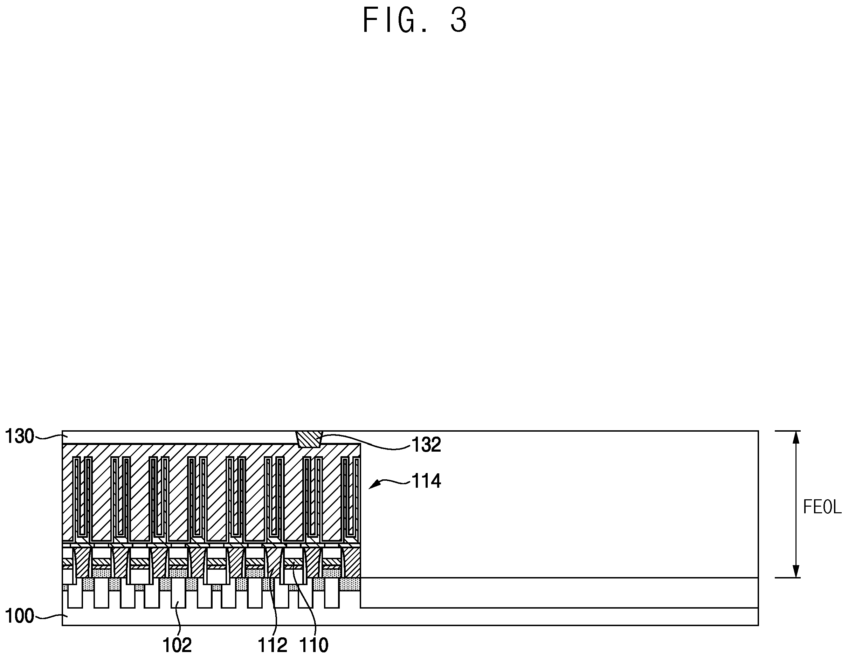

FIGS. 3 to 10 are cross-sectional views illustrating a method of manufacturing a semiconductor device. Referring to FIG. 3, an isolation process may be performed on the substrate 100 to form an isolation pattern 102. After that, a memory cell structure may be on the substrate 100. The memory cell structure may include cell transistors, bit line structures 110, first lower wirings 112 and capacitors 114.

A lower insulating interlayer 130 may be on the substrate 100 to cover the memory cell structure. A contact plug 132 may be further formed in the lower insulating interlayer 130, and the contact plug 132 may be electrically connected to the capacitor 114. The memory cell structure and the lower insulating interlayer 130 may serve as a FEOL structure.

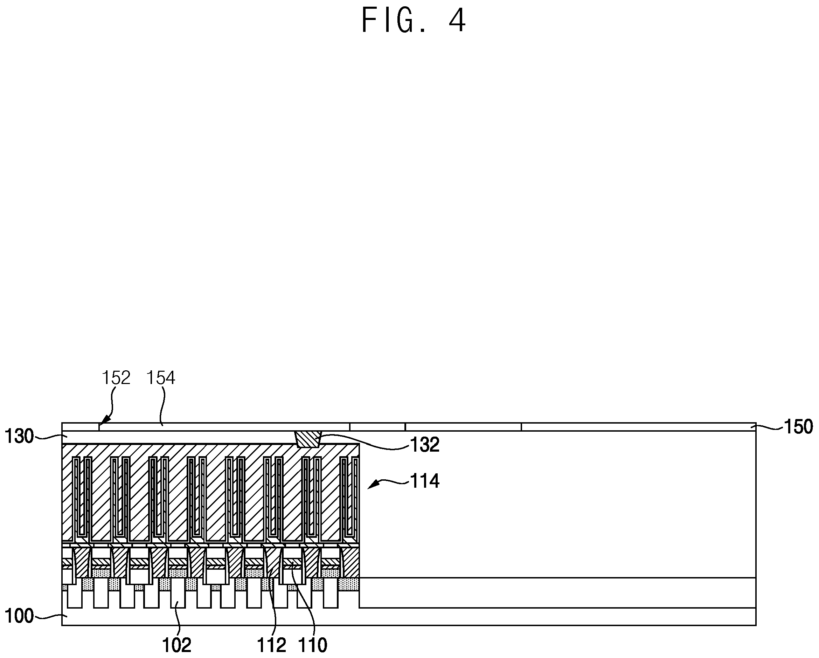

Referring to FIG. 4, a first low-k dielectric layer 150 may be on the lower insulating interlayer 130. A portion of the first low-k dielectric layer 150 may be etched to form a first opening 152. A first metal layer may be formed in the first opening 152, and an upper surface of the first metal layer may be planarized to form a first metal pattern. The first metal pattern may serve as the first wiring 154. As such, the first wiring 154 may be formed by a single damascene process.

In example embodiments, the first wiring 154 may include, e.g., copper. The first wiring 154 may include a metal pattern including copper and a barrier pattern surrounding sidewalls and bottom surfaces of the metal pattern. In an implementation, the barrier pattern may include at least one of titanium, (Ti), tantalum (Ta), and a nitride thereof.

In example embodiments, a first thickness of the first wiring 154 may be in a range of about 1000 Å to about 3000 Å.

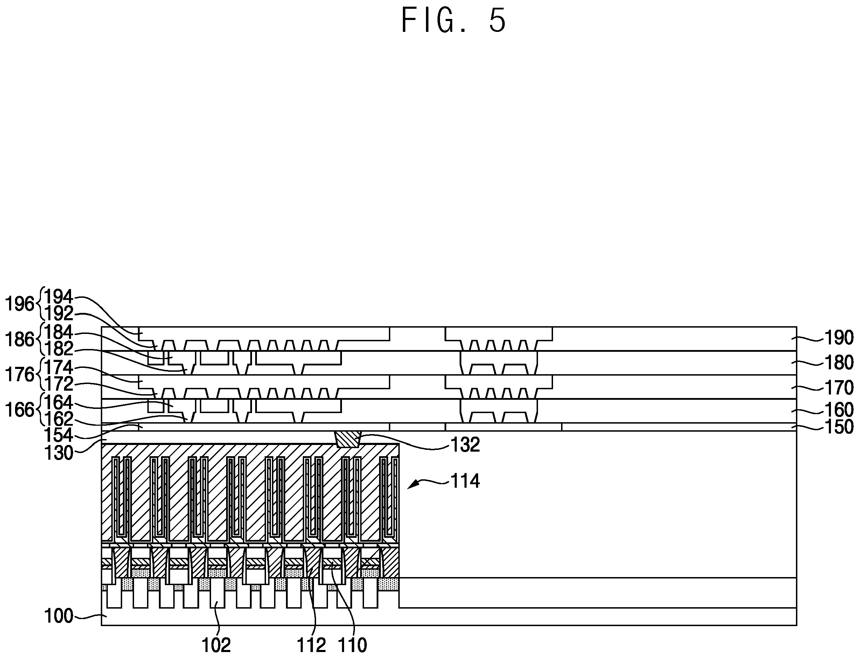

Referring to FIG. 5, a second low-k dielectric layer 160 may be on the first low-k dielectric layer 150 and the first wiring 154. A portion of the second low-k dielectric layer 160 may be etched to form a second via hole. In addition, a second opening communicating with the second via hole may be on the second via hole.

A second metal layer may be formed in the second via hole and the second opening, and an upper surface of the second metal layer may be planarized to form the second via 162 and the second metal pattern 164. The second via 162 and the second metal pattern 164 may serve as a second wiring 166. As such, the second wiring 166 may be formed by a dual damascene process. In example embodiments, the second wiring 166 may include, e.g., copper.

By repeatedly performing the dual damascene process, the third low-k dielectric layer 170, the third wiring 176, the fourth low-k dielectric layer 180, the fourth wiring 186, the fifth low-k dielectric layer 190 and the fifth wiring 196 may be sequentially on the second low-k dielectric layer 160 and the second wiring 166.

The second to fifth wires 166, 176, 186, and 196 may have second to fifth thicknesses, respectively. The second to fifth thicknesses may be the same as or different from each other. In example embodiments, the second to fifth thicknesses may be in range of about 4000 Å to about 8000 Å.

In the n-th wiring (n is e.g., 2 to 5), the thickness of the n-th via may be greater than 50% of the thickness of the n-th metal pattern. Also, the thickness of the n-th via may be less than the thickness of the n-th metal pattern. In an implementation, an n-th via thickness ratio may be about 50% to about 100%.

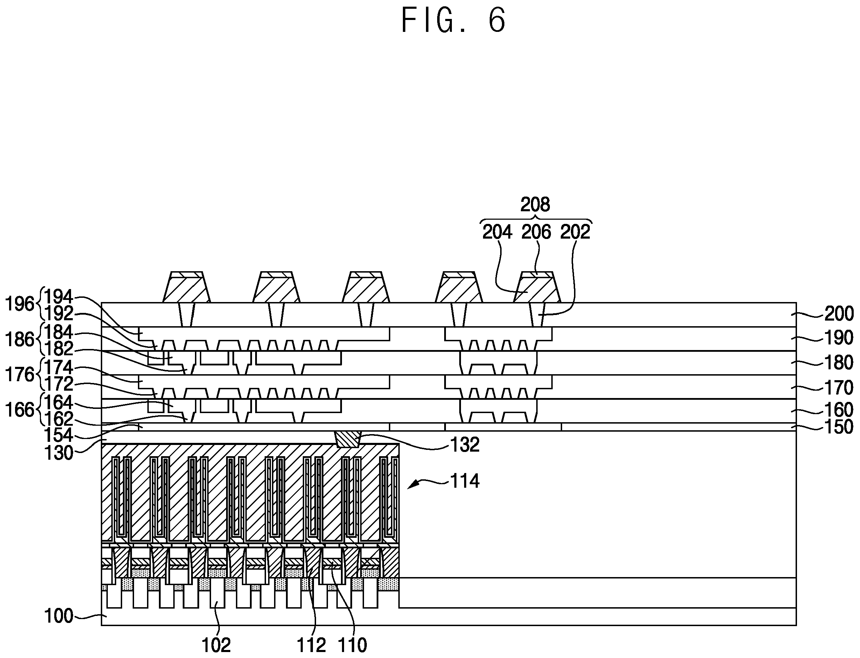

Referring to FIG. 6, a first upper insulating interlayer 200 may be on the fifth low-k dielectric layer 190 and the fifth wiring 196. A portion of the first upper insulating interlayer 200 may be etched to form a sixth via hole. A metal layer may be formed to fill the sixth via hole, and an upper surface of the metal layer may be planarized to form a sixth via 202 in the sixth via hole. The sixth via 202 may include, e.g., tungsten.

The first upper insulating interlayer 200 may be a silicon oxide-based insulation layer. In example embodiments, the first upper insulating interlayer 200 may not be used as an oxide layer for supplying hydrogen. Therefore, the high-density plasma oxide layer may not be included in the first upper insulating interlayer 200.

A sixth metal layer and a first barrier metal layer may be on the first upper insulating interlayer 200 and the sixth via 202. The sixth metal layer may include, e.g., aluminum, tungsten or copper. The first barrier metal layer may include at least one of titanium, (Ti), tantalum (Ta), and a nitride thereof.

The first barrier metal layer and the sixth metal layer may be patterned to form a sixth metal pattern 204 and a first barrier metal pattern 206. Accordingly, a sixth wiring 208 including the sixth via 202 and the sixth metal pattern 204 may be formed. In an implementation, the sixth wiring 208 may further include the first barrier metal pattern 206 on the sixth metal pattern 204.

The sixth wiring 208 may have a sixth thickness. The sixth thickness may be greater than each of the first to fifth thicknesses. In example embodiments, the sixth thickness may be in range of about 7000 Å to about 12000 Å.

A thickness of the sixth via 202 may be greater than 30% of a thickness of the sixth metal pattern 204. Also, the thickness of the sixth via 202 may be less than the thickness of the sixth metal pattern 204. In an implementation, a sixth via thickness ratio may be 30% to 100%. In example embodiments, the sixth via thickness ratio may be less than each of the first to fifth via thickness ratios.

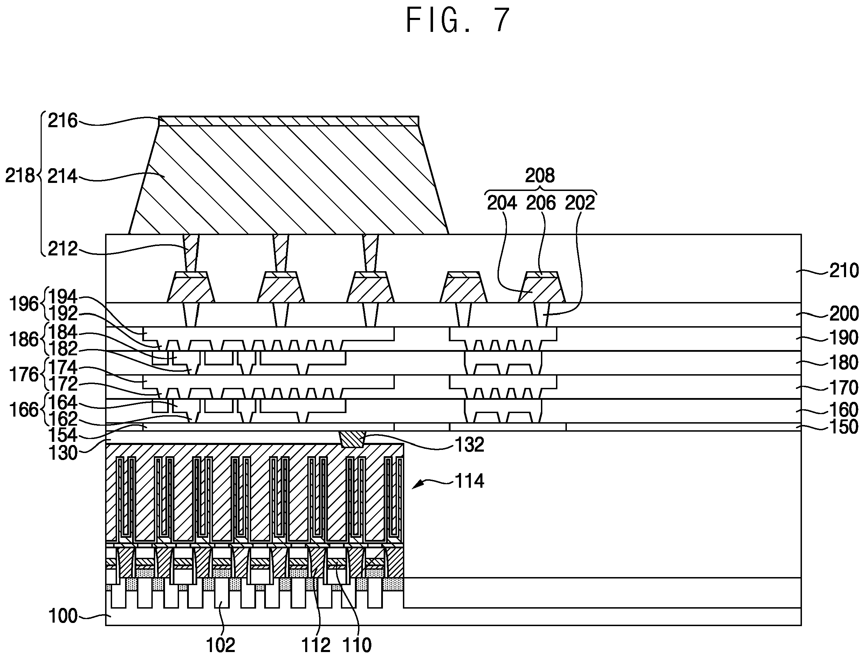

Referring to FIG. 7, a second upper insulating interlayer 210 may be on the first upper insulating interlayer 200 and the sixth metal pattern 204. A portion of the second upper insulating interlayer 210 may be etched to form an uppermost via hole. A metal layer may be formed to fill the uppermost via hole, and the metal layer may be planarized to form an uppermost via 212 in the uppermost via hole. The uppermost via 212 may include, e.g., tungsten. The second upper insulating interlayer 210 may include at least a silicon oxide-based insulation layer.

The second upper insulating interlayer 210 may include one layer, or may include stacked two or more layers including different insulation materials.

In example embodiments, the second upper insulating interlayer 210 may not include silicon nitride. In some example embodiments, the second upper insulating interlayer 210 may include silicon nitride.

In example embodiments, the second upper insulating interlayer 210 may not be used as an oxide layer for supplying hydrogen. In an implementation, the second upper insulating interlayer 210 may not include a high density plasma (HDP) oxide layer.

A seventh metal layer and a second barrier metal layer may be on the second upper insulating interlayer 210 and the uppermost via 212. The seventh metal layer may include, e.g., aluminum. The second barrier metal layer may include at least one of titanium, (Ti), tantalum (Ta), and a nitride thereof.

The second barrier metal layer and the seventh metal layer may be patterned to form an uppermost metal pattern 214 and a second barrier metal pattern 216. Accordingly, an uppermost wiring 218 including the uppermost via 212 and the uppermost metal pattern 214 may be formed. In an implementation, the uppermost wiring 218 may further include the second barrier metal pattern 216 on the uppermost metal pattern 214.

As such, the uppermost via 212 and the uppermost metal pattern 214 included in the uppermost wiring 218 may include different metal materials to each other.

The uppermost wiring 218 may have a seventh thickness. The seventh thickness may be greater than each of the first to sixth thicknesses. In example embodiments, the seventh thickness may be 25,000 Å or more. In an implementation, the seventh thickness may be about 25000 Å to about 45000 Å.

In example embodiments, a thickness of the uppermost metal pattern 214 may be greater than each of the first to sixth thicknesses. **In** example embodiments, the thickness of the uppermost metal pattern 214 may be 20000 Å or more. In an implementation, the thickness of the uppermost metal pattern 214 may be about 20000 Å to about 40000 Å.

A thickness of the uppermost via 212 is less than 40% of the thickness of the uppermost metal pattern 214. In an implementation, the thickness of the uppermost via 212 may be 20% to 35% of the thickness of the uppermost metal pattern 214.

In an embodiment an uppermost via thickness ratio is less than 40%. In example embodiments, the uppermost via thickness ratio may be less than each of the first to sixth thickness ratios.

As such, since the uppermost via thickness ratio is less than 40%, the thickness of the uppermost wiring 218 may be decreased. Therefore, vertical thermal resistance due to the thickness of the uppermost wiring 218 may be decreased.

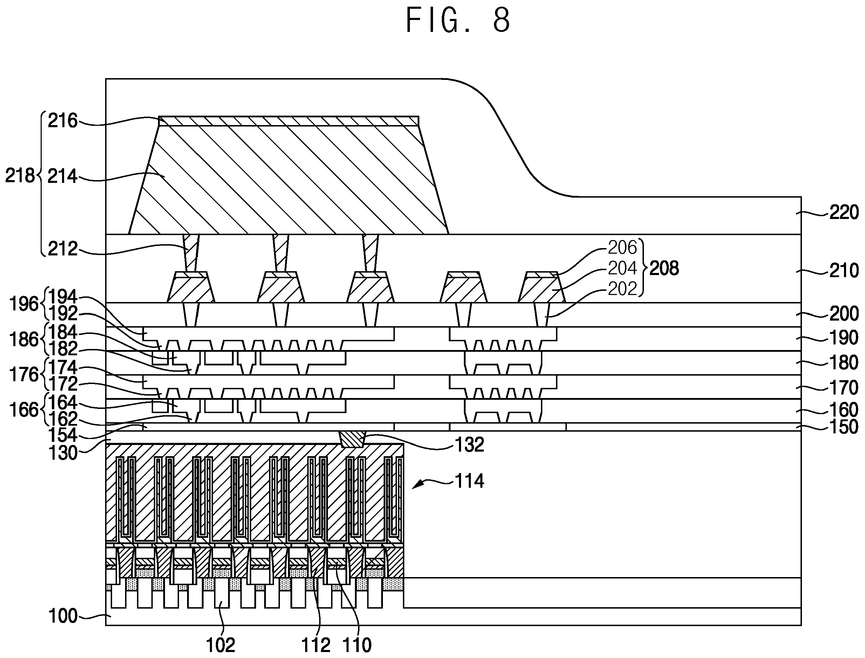

Referring to FIG. 8, an oxide layer 220 for supplying hydrogen is on the second upper insulating interlayer 210 and the uppermost wiring 218 to cover the second upper insulating interlayer 210 and the uppermost wiring 218. The oxide layer 220 for supplying hydrogen may include a high density plasma (HDP) oxide layer.

A thickness of the oxide layer 220 for supplying hydrogen may be greater than 40% of the thickness of the uppermost metal pattern 214, and may be less than the thickness of the uppermost metal pattern 214. In addition, the thickness of the oxide layer 220 for supplying hydrogen may be greater than the thickness of the uppermost via 212. In an implementation, the thickness of the oxide layer 220 for supplying hydrogen may be 10000 Å or more.

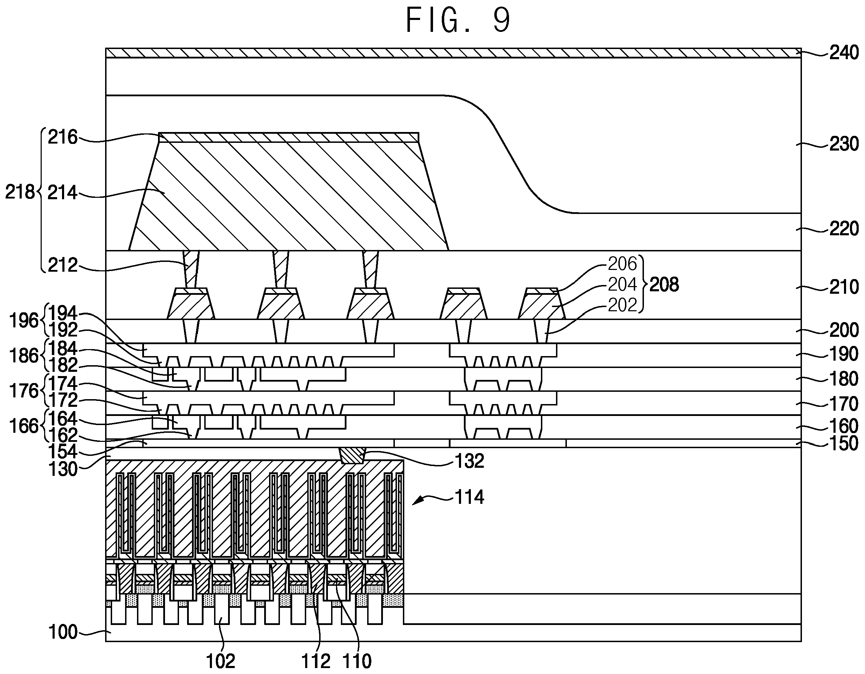

Referring to FIG. 9, an uppermost insulating interlayer 230 may be on the oxide layer 220 for supplying hydrogen. The uppermost insulating interlayer 230 may include an oxide having a high flatness of an upper surface thereof. The uppermost insulating interlayer 230 may include a TEOS layer.

An upper capping layer 240 may be on the uppermost insulating interlayer 230. The upper capping layer 240 may include, e.g., silicon nitride.

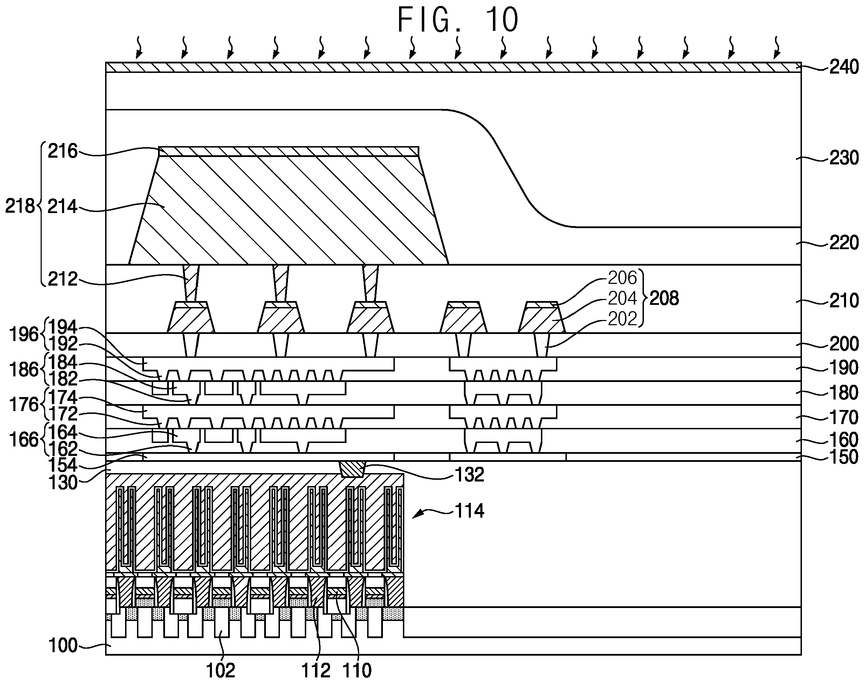

Referring to FIG. 10, an alloy process may be performed to diffuse hydrogen in the oxide layer 220 for supplying hydrogen to the upper surface of the substrate 100.

The alloying process may include heat treatment performed at a temperature of about 300°C to about 500°C, for tens to hundreds of minutes. In the heat treatment process, heat may be applied to the upper capping layer 240, and thus the hydrogen included in the oxide layer 220 for supplying hydrogen may be transferred to the surface of the substrate 100 through multilayer wirings and lower wirings formed thereunder. Thus, dangling bonds at interface between the substrate 100 and the gate insulating layer of the transistor may be removed by the hydrogen.

In the embodiment, the thickness of the uppermost via 212 is less than 40% of the thickness of the uppermost metal pattern 214. Accordingly, the thickness of the uppermost wiring 218 may be decreased, and the vertical thermal resistance of the semiconductor device may be decreased.

The above-described semiconductor device may be used in a memory die included in a high bandwidth memory (HBM). Hereinafter, a high-bandwidth memory including the semiconductor device may be described.

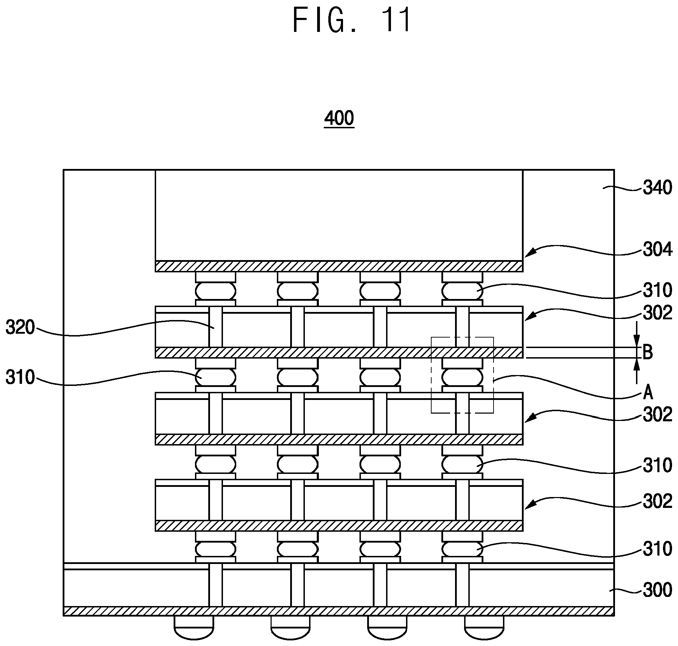

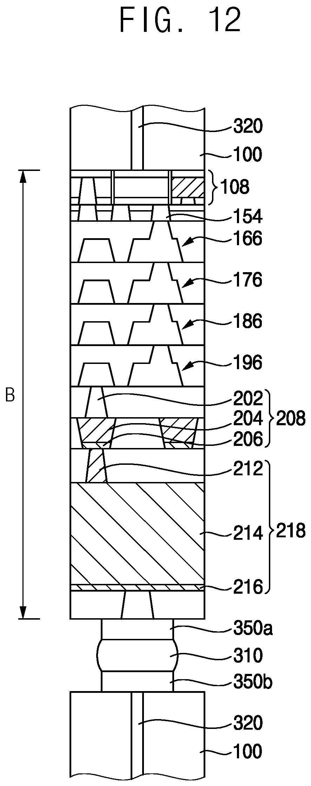

FIG. 11 is a cross-sectional view of a semiconductor device according to according to example embodiments. FIG. 12 is an enlarged view of a portion A of FIG. 11. A portion B in FIG. 12 may correspond to a portion B in FIG. 11.

Referring to FIGS. 11 and 12, the high-bandwidth memory may include a package substrate 300, a plurality of memory dies (i.e., chips 302) and a logic die 304 stacked on the package substrate 300, and a molding member 340. The high-bandwidth memory may further include conductive bumps 310 and external connection terminals.

The package substrate 300 may be a printed circuit board (PCB) including a circuit pattern therein. Board pads may be on an upper surface of the package substrate 300, and the external connection terminals such as solder balls may be on a lower surface of the package substrate 300.

The logic die 304 may be electrically connected to the memory dies 302, and may control operations (e.g., input/output of signals) of the memory dies 302. In example embodiments, the logic die 304 may be positioned on a lowermost layer or an uppermost layer of the package substrate 300. The logic die 304 may be positioned under a lowermost memory die or on an uppermost memory die. In an implementation, as shown in FIG. 11, the logic die 304 may be on the uppermost memory die.

Each of the memory dies 302 may include the semiconductor device according to example embodiments described above. In portions B of FIGS. 11 and 12, in the memory die 302, a memory cell structure 108 may be on the substrate 100, and the first to sixth wirings 154, 166, 176, 186, 196 and 208 and an uppermost wiring 218 may be on the memory cell structure 108. The memory die 302 may be disposed so that an upper surface of the substrate 100 on which the memory cell structure 108 is formed may face downward.

The memory die 302 may include a through-silicon via 320 penetrating the substrate 100. A first bump pad 350a may be connected to the uppermost metal pattern 214. A second bump pad 350b may be connected to the through-silicon via 320.

In upper and lower memory dies 302 adjacent to each other in a vertical direction, the conductive bump 310 may be interposed between the second bump pad 350b contacting the lower memory die and the first bump pad 350a contacting the upper memory die.

In FIGS. 11 and 12 of the high-bandwidth memory device, the memory dies 302 may be stacked in three layers. However, it is not limited thereto. In an implementation, the memory dies 302 may be stacked in 10 or more layers. The number of memory dies stacked in the high-bandwidth memory may be continuously increased, and thus the vertical thermal resistance generated in each of memory dies in the high-bandwidth memory may be increased.

As described above, each of memory dies may include the semiconductor device according to example embodiments. In an implementation, in each of memory dies, the thickness of the uppermost via 212 may be less than 40% of the thickness of the uppermost metal pattern 214. Accordingly, the thickness of the uppermost wiring 218 may be decreased, and thus the vertical thermal resistance may be decreased in each of the memory dies. Therefore, the high-bandwidth memory may have low vertical thermal resistance.

By way of summation and review, example embodiments provide a semiconductor device including an upper wiring structure having low thermal resistance.

## Claims

1. A semiconductor device, comprising:
lower metal wirings (154, 166, 176, 186, 196) on a substrate (100), the lower metal wirings stacked in a plurality of layers;
a first upper insulating interlayer (200) on the lower metal wirings (154, 166, 176, 186, 196);
a first upper wiring (208) including a first upper via (202) in the first upper insulating interlayer (200) and a first upper metal pattern (204) on the first upper insulating interlayer (200);
a second upper insulating interlayer (210) on the first upper insulating interlayer (200), the second upper insulating interlayer covering the first upper metal pattern (204);
an uppermost wiring (218) including an uppermost via (212) in the second upper insulating interlayer (210) and an uppermost metal pattern (214) on the second upper insulating interlayer; and
an oxide layer (220) for supplying hydrogen on the second upper insulating interlayer (210), the oxide layer for supplying hydrogen covering the uppermost wiring (218) including the uppermost metal pattern (214),
wherein a thickness (T7a) of the uppermost via (212) is less than 40% of a thickness (T7b) of the uppermost metal pattern (214), the thickness being measured in a direction normal to a plane of the substrate.

2. The semiconductor device as claimed in claim 1, wherein the thickness of the uppermost metal pattern (214) is 20000 Å to 40000 Å.

3. The semiconductor device as claimed in claim 1 or 2, wherein the thickness of the uppermost via (212) is 20% to 35% of the thickness of the uppermost metal pattern (214).

4. The semiconductor device as claimed in claim 1, 2 or 3, wherein a metal included in the first upper wiring (208) and a metal included in the uppermost wiring (218) are different from a metal included in the lower metal wiring.

5. The semiconductor device as claimed in any one of claims 1 to 4, wherein the uppermost via (212) includes tungsten, and the uppermost metal pattern (214) includes aluminum.

6. The semiconductor device as claimed in any one of claims 1 to 5, wherein each of the lower metal wirings (154, 166, 176, 186, 196) includes a via and a metal pattern, and a thickness of the via is 50% to 100% of a thickness of the metal pattern.

7. The semiconductor device as claimed in any one of claims 1 to 6, wherein an uppermost via (212) thickness ratio, which is the thickness of the uppermost via (212) divided by the thickness of the uppermost metal pattern (214) multiplied by 100, is less than a first upper via (202) thickness ratio, which is the thickness of the first upper via (202) divided by the thickness of the first upper metal pattern (204) multiplied by 100.

8. The semiconductor device as claimed in any one of claims 1 to 7, wherein a thickness of the first upper via (202) in the first upper metal wiring is 30% to 100% of a thickness of the first upper metal pattern (204).

9. The semiconductor device as claimed in any one of claim 1 to 8, wherein the oxide layer (220) for supplying hydrogen includes a high density plasma oxide layer.

10. The semiconductor device as claimed in any one of claims 1 to 9, wherein a thickness of the oxide layer (220) for supplying hydrogen is greater than the thickness of the uppermost via (212).

11. The semiconductor device as claimed in any one of claims 1 to 10, further comprising:
an uppermost insulating interlayer (230) on the oxide layer (220) for supplying hydrogen, the uppermost insulating interlayer including silicon oxide and having a flat upper surface; and
an upper capping layer (240) on the uppermost insulating interlayer.

12. A semiconductor device as claimed in any one of claims 1 to 10, comprising:
memory cells on the substrate (100), the lower metal wirings (154, 166, 176, 186, 196) being on the memory cells;
an uppermost insulating interlayer (230) on the oxide layer (220) for supplying hydrogen, the uppermost insulating interlayer including silicon oxide and having a flat upper surface; and
an upper capping layer (240) on the uppermost insulating interlayer.

13. The semiconductor device as claimed in any one of claims 1 to 12, wherein an uppermost via (212) thickness ratio, which is the thickness of the uppermost via (212) divided by the thickness of the uppermost metal pattern (214) multiplied by 100, is less than a first upper via (202) thickness ratio, which is the thickness of the first upper via (202) divided by the thickness of the first upper metal pattern (204) multiplied by 100.

14. The semiconductor device as claimed in any one of claims 1 to 13, wherein a thickness of the oxide layer (220) for supplying hydrogen is greater than the thickness of the uppermost via (212).

15. The semiconductor device as claimed in any one of claims 1 to 14, wherein a thickness of the uppermost metal pattern (214) is greater than each of a thickness of the first upper wiring (208) and a thickness of lower metal wiring.

## Patentansprüche

1. Halbleitervorrichtung, umfassend:
untere Metallleiterbahnen (154, 166, 176, 186, 196) auf einem Substrat (100), wobei die unteren Metallleiterbahnen in einer Vielzahl von Schichten gestapelt sind;
eine erste obere isolierende Zwischenschicht (200) auf den unteren Leiterbahnen (154, 166, 176, 186, 196);
eine erste obere Leiterbahn (208), die eine erste obere Durchkontaktierung (202) in der ersten oberen isolierenden Zwischenschicht (200) und eine erste obere metallische Struktur (204) auf der ersten oberen isolierenden Zwischenschicht (200) einschließt;
eine zweite obere isolierende Zwischenschicht (210) auf der ersten oberen isolierenden Zwischenschicht (200), wobei die zweite obere isolierende Zwischenschicht die erste obere metallische Struktur (204) bedeckt;
eine oberste Leiterbahn (218), die eine oberste Durchkontaktierung (212) in der zweiten oberen isolierenden Zwischenschicht (210) und eine oberste metallische Struktur (214) auf der zweiten oberen isolierenden Zwischenschicht einschließt; und
eine Oxidschicht (220) zur Zuführung von Wasserstoff auf der zweiten oberen isolierenden Zwischenschicht (210), wobei die Oxidschicht zur Zuführung von Wasserstoff die oberste Leiterbahn (218) einschließlich der obersten metallischen Struktur (214) bedeckt,
wobei eine Dicke (T7a) der obersten Durchkontaktierung (212) weniger als 40 % einer Dicke (T7b) der obersten metallischen Struktur (214) beträgt, wobei die Dicke in einer Richtung senkrecht zu einer Ebene des Substrats gemessen wird.

2. Halbleitervorrichtung nach Anspruch 1, wobei die Dicke der obersten metallischen Struktur (214) 20.000 Å bis 40.000 Å beträgt.

3. Halbleitervorrichtung nach Anspruch 1 oder 2, wobei die Dicke der obersten Durchkontaktierung (212) 20 % bis 35 % der Dicke der obersten metallischen Struktur (214) beträgt.

4. Halbleitervorrichtung nach Anspruch 1, 2 oder 3, wobei ein in der ersten oberen Leiterbahn (208) eingeschlossenes Metall und ein in der obersten Leiterbahn (218) eingeschlossenes Metall sich von einem in der unteren Metallleiterbahn eingeschlossenen Metall unterscheiden.

5. Halbleitervorrichtung nach einem der Ansprüche 1 bis 4, wobei die oberste Durchkontaktierung (212) Wolfram einschließt und die oberste metallische Struktur (214) Aluminium einschließt.

6. Halbleitervorrichtung nach einem der Ansprüche 1 bis 5, wobei jede der unteren Metallleiterbahnen (154, 166, 176, 186, 196) eine Durchkontaktierung und eine metallische Struktur einschließt und eine Dicke der Durchkontaktierung 50 % bis 100 % einer Dicke der metallischen Struktur beträgt.

7. Halbleitervorrichtung nach einem der Ansprüche 1 bis 6, wobei ein Dickenverhältnis der obersten Durchkontaktierung (212), welches die Dicke der obersten Durchkontaktierung (212) dividiert durch die Dicke der obersten metallischen Struktur (214) und multipliziert mit 100 ist, kleiner ist als ein Dickenverhältnis der ersten oberen Durchkontaktierung (202), welches die Dicke der ersten oberen Durchkontaktierung (202) dividiert durch die Dicke der ersten oberen metallischen Struktur (204) und multipliziert mit 100 ist.

8. Halbleitervorrichtung nach einem der Ansprüche 1 bis 7, wobei eine Dicke der ersten oberen Durchkontaktierung (202) in der ersten oberen Leiterbahn 30 % bis 100 % der Dicke der ersten oberen metallischen Struktur (204) beträgt.

9. Halbleitervorrichtung nach einem der Ansprüche 1 bis 8, wobei die Oxidschicht (220) zur Zuführung von Wasserstoff eine Plasmaoxidschicht hoher Dichte einschließt.

10. Halbleitervorrichtung nach einem der Ansprüche 1 bis 9, wobei eine Dicke der Oxidschicht (220) zur Zuführung von Wasserstoff größer als die Dicke der obersten Durchkontaktierung (212) ist.

11. Halbleitervorrichtung nach einem der Ansprüche 1 bis 10, ferner umfassend:
eine oberste isolierende Zwischenschicht (230) auf der Oxidschicht (220) zur Zuführung von Wasserstoff, wobei die oberste isolierende Zwischenschicht Siliziumoxid einschließt und eine ebene Oberseite aufweist; und
eine obere Deckschicht (240) auf der obersten isolierenden Zwischenschicht.

12. Halbleitervorrichtung nach einem der Ansprüche 1 bis 10, umfassend:
Speicherzellen auf dem Substrat (100), wobei die unteren Metallleiterbahnen (154, 166, 176, 186, 196) sich auf den Speicherzellen befinden;
eine oberste isolierende Zwischenschicht (230) auf der Oxidschicht (220) zur Zuführung von Wasserstoff, wobei die oberste isolierende Zwischenschicht Siliziumoxid einschließt und eine ebene Oberseite aufweist; und
eine obere Deckschicht (240) auf der obersten isolierenden Zwischenschicht.

13. Halbleitervorrichtung nach einem der Ansprüche 1 bis 12, wobei ein Dickenverhältnis der obersten Durchkontaktierung (212), welches die Dicke der obersten Durchkontaktierung (212) dividiert durch die Dicke der obersten metallischen Struktur (214) und multipliziert mit 100 ist, kleiner ist als ein Dickenverhältnis der ersten oberen Durchkontaktierung (202), welches die Dicke der ersten oberen Durchkontaktierung (202) dividiert durch die Dicke der ersten oberen metallischen Struktur (204) und multipliziert mit 100 ist.

14. Halbleitervorrichtung nach einem der Ansprüche 1 bis 13, wobei eine Dicke der Oxidschicht (220) zur Zuführung von Wasserstoff größer als die Dicke der obersten Durchkontaktierung (212) ist.

15. Halbleitervorrichtung nach einem der Ansprüche 1 bis 14, wobei eine Dicke der obersten metallischen Struktur (214) größer als jede einer Dicke der ersten oberen Leiterbahn (208) und einer Dicke der unteren Metallleiterbahn ist.

## Revendications

1. Dispositif à semi-conducteur, comprenant :
des câblages métalliques inférieurs (154, 166, 176, 186, 196) sur un substrat (100), les câblages métalliques inférieurs étant empilés en une pluralité de couches ;
une première couche intermédiaire isolante supérieure (200) sur les câblages métalliques inférieurs (154, 166, 176, 186, 196) ;
un premier câblage supérieur (208) incluant un premier trou d'interconnexion supérieur (202) dans la première couche intermédiaire isolante supérieure (200) et un premier motif métallique supérieur (204) sur la première couche intermédiaire isolante supérieure (200) ;
une seconde couche intermédiaire isolante supérieure (210) sur la première couche intermédiaire isolante supérieure (200), la seconde couche intermédiaire isolante supérieure couvrant le premier motif métallique supérieur (204) ;
un câblage le plus haut (218) incluant un trou d'interconnexion le plus haut (212) dans la seconde couche intermédiaire isolante supérieure (210) et un motif métallique le plus haut (214) sur la seconde couche intermédiaire isolante supérieure ; et
une couche d'oxyde (220) pour fournir de l'hydrogène sur la seconde couche intermédiaire isolante supérieure (210), la couche d'oxyde pour fournir de l'hydrogène couvrant le câblage le plus haut (218) incluant le motif métallique le plus haut (214),
dans lequel l'épaisseur (T7a) du trou d'interconnexion le plus haut (212) est inférieure à 40 % de l'épaisseur (T7b) du motif métallique le plus haut (214), l'épaisseur étant mesurée dans une direction normale à un plan du substrat.

2. Dispositif à semi-conducteur selon la revendication 1, dans lequel l'épaisseur du motif métallique le plus haut (214) est de 20 000 Å à 40 000 Å.

3. Dispositif à semi-conducteur selon la revendication 1 ou 2, dans lequel l'épaisseur du trou d'interconnexion le plus haut (212) est égale à 20 % à 35 % de l'épaisseur du motif métallique le plus haut (214).

4. Dispositif à semi-conducteur selon la revendication 1, 2 ou 3, dans lequel un métal inclus dans le premier câblage supérieur (208) et un métal inclus dans le câblage le plus haut (218) sont différents d'un métal inclus dans le câblage métallique inférieur.

5. Dispositif à semi-conducteur selon l'une quelconque des revendications 1 à 4, dans lequel le trou d'interconnexion le plus haut (212) inclut du tungstène et le motif métallique le plus haut (214) inclut de l'aluminium.

6. Dispositif à semi-conducteur selon l'une quelconque des revendications 1 à 5, dans lequel chacun des câblages métalliques inférieurs (154, 166, 176, 186, 196) inclut un trou d'interconnexion et un motif métallique, et l'épaisseur du trou d'interconnexion est égale à 50 % à 100 % de l'épaisseur du motif métallique.

7. Dispositif à semi-conducteur selon l'une quelconque des revendications 1 à 6, dans lequel un rapport d'épaisseur de trou d'interconnexion le plus haut (212), qui est l'épaisseur du trou d'interconnexion le plus haut (212) divisée par l'épaisseur du motif métallique le plus haut (214) multipliée par 100, est inférieur à un rapport d'épaisseur de premier trou d'interconnexion supérieur (202), qui est l'épaisseur du premier trou d'interconnexion supérieur (202) divisée par l'épaisseur du premier motif métallique supérieur (204) multipliée par 100.

8. Dispositif à semi-conducteur selon l'une quelconque des revendications 1 à 7, dans lequel l'épaisseur du premier trou d'interconnexion supérieur (202) dans le premier câblage métallique supérieur est égale à 30 % à 100 % de l'épaisseur du premier motif métallique supérieur (204).

9. Dispositif à semi-conducteur selon l'une quelconque des revendications 1 à 8, dans lequel la couche d'oxyde (220) pour fournir de l'hydrogène inclut une couche d'oxyde de plasma à haute densité.

10. Dispositif à semi-conducteur selon l'une quelconque des revendications 1 à 9, dans lequel l'épaisseur de la couche d'oxyde (220) pour fournir de l'hydrogène est plus grande que l'épaisseur du trou d'interconnexion le plus haut (212).

11. Dispositif à semi-conducteur selon l'une quelconque des revendications 1 à 10, comprenant en outre :
une couche intermédiaire isolante la plus haute (230) sur la couche d'oxyde (220) pour fournir de l'hydrogène, la couche intermédiaire isolante la plus haute incluant de l'oxyde de silicium et présentant une surface supérieure plane ; et
une couche de recouvrement supérieure (240) sur la couche intermédiaire isolante la plus haute.

12. Dispositif à semi-conducteur selon l'une quelconque des revendications 1 à 10, comprenant :
des cellules de mémoire sur le substrat (100), les câblages métalliques inférieurs (154, 166, 176, 186, 196) étant sur les cellules de mémoire ;
une couche intermédiaire isolante la plus haute (230) sur la couche d'oxyde (220) pour fournir de l'hydrogène, la couche intermédiaire isolante la plus haute incluant de l'oxyde de silicium et présentant une surface supérieure plane ; et
une couche de recouvrement supérieure (240) sur la couche intermédiaire isolante la plus haute.

13. Dispositif à semi-conducteur selon l'une quelconque des revendications 1 à 12, dans lequel un rapport d'épaisseur de trou d'interconnexion le plus haut (212), qui est l'épaisseur du trou d'interconnexion le plus haut (212) divisée par l'épaisseur du motif métallique le plus haut (214) multipliée par 100, est inférieur à un rapport d'épaisseur de premier trou d'interconnexion supérieur (202), qui est l'épaisseur du premier trou d'interconnexion supérieur (202) divisée par l'épaisseur du premier motif métallique supérieur (204) multipliée par 100.

14. Dispositif à semi-conducteur selon l'une quelconque des revendications 1 à 13, dans lequel l'épaisseur de la couche d'oxyde (220) pour fournir de l'hydrogène est plus grande que l'épaisseur du trou d'interconnexion le plus haut (212).

15. Dispositif à semi-conducteur selon l'une quelconque des revendications 1 à 14, dans lequel l'épaisseur du motif métallique le plus haut (214) est plus grande que chacune de l'épaisseur du premier câblage supérieur (208) et de l'épaisseur du câblage métallique inférieur.
